(19) **Europäisches Patentamt**
**European Patent Office**
**Office européen des brevets**

(11) **EP 4 009 324 A1**

(12) **EUROPEAN PATENT APPLICATION**

(43) Date of publication:
**08.06.2022 Bulletin 2022/23**

(21) Application number: **20211514.3**

(22) Date of filing: **03.12.2020**

(51) International Patent Classification (IPC):
**G11C 11/16** $^{(2006.01)}$        **H01L 43/10** $^{(2006.01)}$

(52) Cooperative Patent Classification (CPC):
**G11C 11/16; G11C 11/1675; H01L 43/08; H01L 43/10**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Max-Planck-Gesellschaft zur Förderung der Wissenschaften e.V.**
**80539 München (DE)**

(72) Inventors:
• **PARKIN, Stuart S. P.**
**06118 Halle (DE)**
• **JENA, Jagannath**
**06122 Halle (DE)**

(74) Representative: **Schweitzer, Klaus et al**
**Plate Schweitzer Zounek**
**Patentanwälte**
**Rheingaustrasse 196**
**65203 Wiesbaden (DE)**

(54) **ANTISKYRMIONS AND ELLIPTICAL SKYRMIONS IN NANO-STRIPES**

(57)    The present invention relates to nano-stripes of a compound, which crystallizes in the magnetic point group $\bar{4}2m$ with *D2d* symmetry wherein the nano-stripes have
- a thickness of 5-500 nm,
- a width of 10-1000 nm, and
- a length of 100-10000 nm

wherein these nano-stripes exhibit magnetic nano-objects of specified magnetic spin textures. The invention also relates to the use of this material in spintronic applications, such as memory storage systems, and particularly memory storage systems that use current to move these magnetic nano-objects, specifically in a magnetic racetrack.

Figure 1

EP 4 009 324 A1

**Description**

The present invention relates to magnetic materials with $D_{2d}$ symmetry that exhibit magnetic nano-objects with certain magnetic spin textures. The invention also relates to the use of these materials in spintronic applications, such as memory storage systems, and particularly memory storage systems that use current to move these magnetic nano-objects, specifically in a magnetic racetrack.

Background

Racetrack memory devices are gaining interest as high-density storage devices. These devices are disclosed, for example, in US-B 6,834,005. More advanced racetrack memory cells have already been developed including vertical nanowire storage elements, as disclosed e.g. in US-A 2014/204648.

Especially, racetrack devices based on chiral domain wall (DW) magnetic bits in perpendicularly magnetized ferromagnet/heavy-metal thin film systems are a promising candidate for next generation spintronic memories (US-A 2014/0009994, US-A 2014/0009993). These currents can be used, in particular, to manipulate magnetic bits that are encoded in nano-objects with certain magnetic spin textures (domains, skyrmions, or antiskyrmions) in nanoscale racetracks.

Current-induced domain wall motion (CIDWM) has significantly evolved from in-plane magnetic to synthetic antiferromagnetic (SAF) racetracks due to advances in volume spin-transfer torque (STT) and spin-orbit-torque (SOT) mechanisms. Driven by a chiral spin torque that arises from the spin-orbit coupling in the presence of broken inversion symmetry at ferromagnet/heavy-metal (HM) interfaces, Néel domain walls in thin films with strong perpendicular magnetic anisotropy (PMA), stabilized by a Dzyaloshinskii-Moriya interaction (DMI) at the ferromagnet/HM interfaces, can be moved along the current direction at high velocities (e.g. EP3171364A1), in both straight and curved racetracks. The fast and energy efficient motion of such magnetic bits along 2D or 3D racetracks by spin current is a key challenge for its commercial implementation.

An even more efficient DW motion was reported in synthetic antiferromagnet (SAF) racetracks that are composed of two perpendicularly magnetized ferromagnetic sub-racetracks coupled antiferromagnetically across an ultrathin ruthenium layer. The giant exchange coupling torque (ECT) in the SAF structure provides an additional dominating driving mechanism that allows for an increased DW propagation velocity beyond ~1,000 m/s. The ECT in rare earth-transition metal alloys is further maximized at the angular momentum compensation temperature of the ferrimagnetic alloy. Recently, efficient CIDWM was also found in certain magnetic insulators.

Significant progress has been made regarding a detailed understanding of the interface derived chiral spin torque and magnetic chirality with respect to the underlying mechanisms of CIDWM.

Object of the Invention

However, the nano-object velocity is still too low and the threshold current densities are still too high for commercially feasible fast and low power racetrack memory devices. Also, the concept of the presence or absence (corresponding to "0" and "1" bits) of a single object, like a domain wall, at predefined positions is still susceptible to diffusion or interactions and would result in an unstable/unreliable memory device. It would, thus, be desirable to have a material, which exhibits at least two distinguishable nano-objects, one of which can be encoded as a "0" bit and at least another one of which can be encoded as a "1" bit, and which nano-objects move at higher velocity and/or at lower threshold current density than conventional nano-objects.

Brief description of the Invention

The present invention significantly reduces the threshold current densities and increases the velocity of nano-objects, and reduces diffusion and/or interactions of/between these nano-objects, by providing nano-stripes of a magnetic material with $D_{2d}$ symmetry which exhibit both elliptical Bloch skyrmions and antiskyrmions wherein the nano-stripes are geometrically confined so that the nano-stripes have

- a thickness of 5-500 nm,
- a width of 10-1000 nm, and
- a length of 100-10000 nm.

Skyrmions and antiskyrmions are topologically protected nanoscopic vortices of magnetization. These non-collinear topological spin textures arise as a result of a competition between the Heisenberg exchange mechanism and antisymmetric Dzyaloshinskii-Moriya exchange Interactions (DMI). Depending on the helicity of spin rotation, different types of skyrmion textures can be observed, such as Bloch and Neel skyrmions and very recently antiskyrmions (see attached Skyrmion Figure). Skyrmions can be laterally displaced by very low current densities ($10^5$ -$10^6$ A/m$^2$) and, thus, can improve the energy efficiency of information storage devices.

Antiskyrmions can move with even higher velocities at the same current densities or with similarly high velocities, but at lower current densities than conventional magnetic domain walls (DW).

In one aspect of the invention a magnetic material with $D_{2d}$ symmetry is provided which can sustain two distinct magnetic nano-objects, each with chiral boundaries, namely antiskyrmions and Bloch skyrmions, specifically elliptical Bloch skyrmions. Single and double chains of antiskyrmions can be generated at room temperature in nano-stripes according to the present invention, with widths ranging from 10 to 1000 nm, preferably from 200 to 750 nm and most preferred from 350 to 500 nm, formed from a magnetic material with $D_{2d}$ symmetry, such as $Mn_{1.4}PtSn$, $Mn_{1.4}Pt_{0.9}Pd_{0.1}Sn$, $Mn_2RhSn$, $Mn_2IrSn$, $Mn_2Rh_{0.95}Ir_{0.05}Sn$, $Mn_2NiGa$, $Mn_2PtIn$, $Mn_2NiSb$, $Ni_2MnGa$, $Co_2MnGa$, $Cu_2MnSb$, $NiCrSi$, $NiCrGe$, $NiCrGa$, etc. Further $D2d$ compounds are chalcopyrites like $CuFeS_2$, stannites like $Cu_2FeSnS_4$, $Cu_2MnSnS_4$, $Cu_2CoSnS_4$ $Cu_2Mn_{0.4}Fe_{0.6}SnS_4$, $Cu_2CoSi(Ge,Sn)S_4$ and $Cu_2CoSnSe_4$.

Typically, truncated helical spin textures are formed in low magnetic fields in such nano-stripes, whose edges are terminated by half antiskyrmions. These evolve into chains of antiskyrmions with increasing magnetic field. These chains can also include elliptical Bloch skyrmions depending on details of the applied magnetic field history. A compelling feature of these chains is that single chains of these objects are located in the middle of the nano-stripes even when the stripes are much wider than the antiskyrmion size, thereby making $D_{2d}$ materials highly interesting for applications such as magnetic racetrack memory-storage devices.

Definition of terms

The Term *nano-objects* encompasses magnetic nano-objects of a specified magnetic spin texture, specifically Bloch skyrmions and antiskyrmions.

The Term *nano-stripes* encompasses material of quasi 2-dimensional shape with a width so that the number of antiskyrmion rows, which can be generated on its surface is less than three. Typically, this is a material with a thickness of 5-500 nm, preferably 20-300 nm, more preferred 130-250 nm. Typically, these nano-stripes have a width of 10-1000 nm, preferably 200-750 nm, more preferred 350 to 500 nm and a length of 100-10000 nm, preferably 3000-8000 nm, more preferred 5000 - 6000 nm.

*Extended lamella* means a thin specimen that has a dimension of larger than three antiskyrmions in extent so that one can see a lattice of antiskyrmions. At least three rows of antiskyrmions are needed to form a triangular lattice. Accordingly, a stripe having a stripe width for which the number of antiskyrmions row is three and more is an extended lamella. Known extended lamellae have a width of about >1000-6000 nm and a length of about 4500- 6000 nm.

$D_{2d}$ *materials/compounds* encompasses binary, ternary, quaternary etc. compounds which crystallize in the magnetic point group $\overline{4}2m$ with $D2d$ symmetry; especially tetragonal ferro-, ferri- or antiferro-magnetic Heusler compounds, chalcopyrites or stannites. The tetragonal magnetic Heusler compounds have a composition of TT'Z (half-Heusler) or $T_2T'R$ (Heusler or full-Heusler), wherein T and T' are selected from the group consisting of transition metals and Z and R is an element from IUPAC group 13, 14 or 15. T' can also be replaced by two different transition metals $T'_x$ and $T''_{1-x}$ (with x preferably being 0.10 - 0.50). In order to crystallize in the magnetic point group D2d, the Heusler compounds need to crystallize in a non-centrosymmetric space group, like a tetragonal space group. A Heusler compound which does not crystallize in a non-centrosymmetric space group can be "forced" into a non-centrosymmetric distortion e.g. by replacing part of the transition metal T' with a different transition metal T" (see above formulae; preferably x=0.10-0.50) and/or by "reducing" the amount of T to 0.10 - 0.50 below 1 (half-Heusler) or 2 (Heusler or full-Heusler) respectively. Typical Heusler compounds, which can be used in the present invention are $Mn_{1.4}PtSn$, $Mn_{1.4}Pt_{0.9}Pd_{0.1}Sn$, $Mn_2RhSn$, $Mn_2IrSn$, $Mn_2Rh_{0.95}Ir_{0.05}Sn$, $Mn_2NiGa$, $Mn_2PtIn$, $Mn_2NiSb$, $Ni_2MnGa$, $Co_2MnGa$, $Cu_2MnSb$, $NiCrSi$, $NiCrGe$, $NiCrGa$, etc. Further $D2d$ compounds are chalcopyrites like $CuFeS_2$, stannites like $Cu_2FeSnS_4$, $Cu_2MnSnS_4$, $Cu_2CoSnS_4$ $Cu_2Mn_{0.4}Fe_{0.6}SnS_4$, $Cu_2CoSi(Ge,Sn)S_4$ and $Cu_2CoSnSe_4$.

*Elliptical or elliptically elongated Bloch skyrmions* are Bloch skyrmions which are not circular but have the form of elliptically elongated circles, preferably with an a/b ratio of 1.1 to 1.5 (with a, b representing the maximum and minimum radius of the ellipse). The elongation directions (= direction of the longer a-axis) of elliptical Bloch skyrmions are either along the crystallographic [100] or [010] direction, which also correspond to the propagation direction of the helices.

*Chiral boundary* signifies the variation of the spin direction along the radius of the skyrmion. The boundary, which is formed from Block-like spin propagations or Neel-like spin propagations is called a chiral boundary. Bloch skyrmions and Neel skyrmions both exhibit a single type of chiral boundary. An antiskyrmion exhibits two distinct types of spin textures, which form chiral boundaries: Bloch-like (along [100] and [010]) and Neel-like (along [110] and [$\overline{1}$10]).

*Truncated helical spin textures* are short helices, which have the same topological charge as antiskyrmions.

Truncated helices can also be called elongated antiskyrmions.

*Half-antiskyrmions* are formed at the opposing ends of truncated helical spin textures. The end portions each have a winding number (topological charge) of +1/2. Since each truncated helix comprises two half antiskyrmions (one at each end), as a whole it has a topological charge of +1.

*Topological charge* is the product of "polarity" (P) and "vorticity" (M). P defines the direction of the magnetization at the core of the spin texture. The sense of rotation of the in-plane magnetic texture is characterize by the quantity vorticity. An antiskyrmion has opposite M to that of a Bloch or Néel skyrmion and hence opposite topological charge for a given direction of a (fixed) core (polarity).

*Topologically protected* means that a given physical state - like spin - cannot be transformed from state "A" to a state "B" and then back to its starting state "A" by a continuous deformation process. In this scenario, state "A" is topologically protected. As an example: a skyrmion is separated from the ferromagnetic state by an energy barrier that leads to a longer metastability of the skyrmion. The topological charge for a helix or a (field polarized) ferromagnet is zero (=0), but a skyrmion has fixed topological charge of $\neq 0$. Since different topological numbers are assigned for helices and skyrmions, these structures cannot be transformed into one another by a continuous deformation process (in a given system). Therefore, skyrmions are topologically protected objects.

*Confinement, confine (geometric, crystallographic etc.)* means the at least 2-dimensionally defined orientation and alignment of a given specimen, like a nano-stripe or nano-disk in a pre-defined crystallographic direction (defined e.g. by its [*hkl*]-indices) and with a predefined physical size, i.e. planar dimension.

Brief description of the Figures

The Skyrmion Figure shows three distinct types of topological spin textures: Bloch skyrmions (Skyrmion Fig. top, left), Antiskyrmions (Skyrmion Fig. top, center) and Neel skyrmions (Skyrmion Fig. top, right). The cross-sections of the respective spin textures along radial directions show a transverse helix for Bloch skyrmions (Skyrmion Fig. bottom, left), a cycloid for Neel skyrmions (Skyrmion Fig. bottom, right) and an alternating cycloid and transverse helix around the circumference of the nano-object for antiskyrmions (Skyrmion Fig. bottom, center). Skyrmions and antiskyrmions have opposite topological charge.

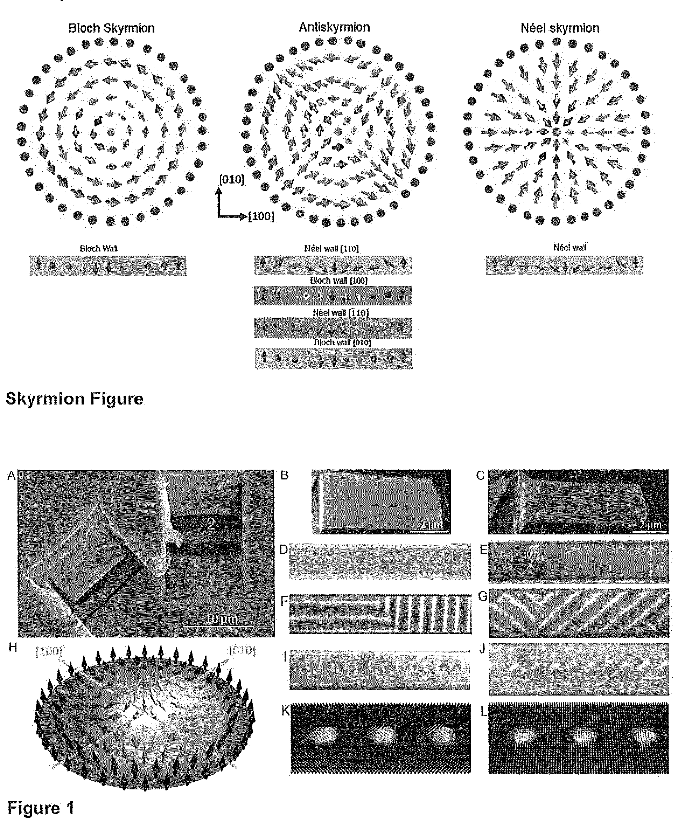

Figure 1 shows spin textures in oriented nano-stripes. (A) SEM (scanning electron microscopy) image of the host material after the nano-stripes have been formed and lifted out by FIB (focussed ion beam) milling. [010] and [110] oriented nano-stripes that were fabricated from (A) are shown in the SEM images in (B) and (C). (D, E) Brightfield TEM (transmission electron microscopy) images of portions of nano-stripes with indicated widths and crystallographic axes. (F, G) Lorentz TEM (LTEM) images of the magnetic texture at zero field in the two nano-stripes that show the formation of helices whose Q-vectors are oriented along the [100] and [010] directions, in both cases. (H) Schematic representation of a magnetic antiskyrmion, where the color encodes the orientation of the magnetic moments. The Bloch parts of the antiskyrmion are along the family of {10} directions (orange), while the Neel parts are along the {11} directions. (I,J) LTEM images of antiskyrmion chains measured in magnetic fields of 187 and 273 mT respectively, oriented perpendicular to the plane of the nano-stripes. The bright and dark regions correspond to the antiskyrmions' Bloch parts oriented along [100]. (K, L) Micromagnetic simulations of the spin textures in nano-stripes with orientations corresponding to those in (I, J) respectively. The color code represents the direction of the moment within each cell used in the simulation. The color code used throughout the present description is as follows: Black means along +z, white means along -z and hue colors stand for in-plane orientations with respect to the [100] direction (e.g. blue arrows always point along the [100] direction).

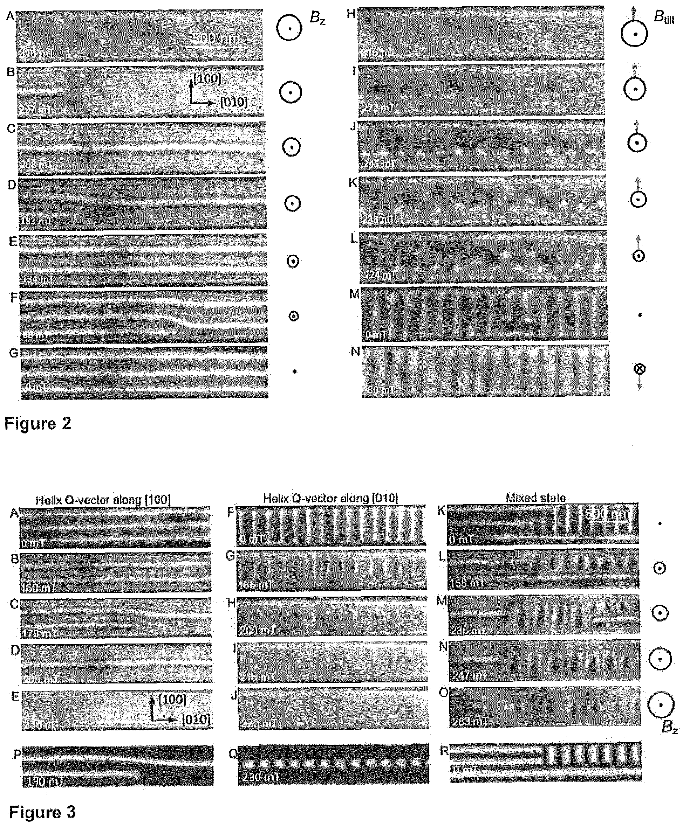

Figure 2 shows helix formation upon decreasing the magnetic field. In the left column, the magnetic field is decreased starting from 316 mT in (A) corresponding to the ferromagnetic phase. (B) 227 mT: a single helix segment forms along the [010] direction (along the nano-track), elongates and finally extends over the whole stripe region in (C) at 208 mT. (D) 183 mT: a second helix segment forms, that elongates in (E) at 134 mT. (F) At 88 mT a third segment forms. (G) At zero field, the ground state is formed: three parallel helix segments along the nano-stripe. In the right row, the magnetic field is decreased under tilting of the sample by ~21°. (H) The starting configuration is again the ferromagnetic phase at 316 mT. (I) 272 mT: non-collinear spin textures form already at higher magnetic fields. An irregular chain of antiskyrmions has formed. (J) At 245 mT more of those have formed and the chain is rather periodic. (K) 233 mT: they begin to elongate along the [100] direction (perpendicular to the nano-track direction). (L) 224 mT: a mixed state has formed. (M) At zero field, the magnetic texture is not perfectly ordered. (N) At small negative fields, a periodic helical state is formed. Using this tilted field, the helical segments are oriented along the [100] direction rather than [010].

Figure 3 shows antiskyrmion and helix formation upon increasing the magnetic field. On the left side, the starting configuration (A) is a helical phase with helix segments along [010]. (B-E) the three individual segments shrink and disappear one after another upon increasing the magnetic field as indicated. In the middle column, the helix segments are initially oriented along the [100] direction, the narrow width of the nano-stripe (F). (G) Again, they shrink but this time antiskyrmions form in (H) at 200 mT. (I) 215 mT: the antiskyrmions annihilate. (J) At 225 mT, the ferromagnetic phase is restored. In the right column, the initial configuration (K) is a mixed helical state with Q-vectors along [100] and [010]. (L) 158 mT: the helix segments shrink. (M) 236 mT: the interaction of them leads to segments of different sizes along [100]. (N) Once the helix segment at the bottom right edge has disappeared, the smaller segments expand upon relaxation. (O) Even at 283 mT, the antiskyrmion on the very left has a slightly different contrast compared to the other antiskyrmions. This is because small deformations along [100] and [010] are still present, corresponding to the initial helix type. (P-R) Results of micromagnetic simulations exemplarily showing the metastability of (P) a mixture of one and two horizontal helix segments, (Q) a chain of antiskyrmions, and (R) a mixture of horizontal and vertical helix segments (see Methods for details).

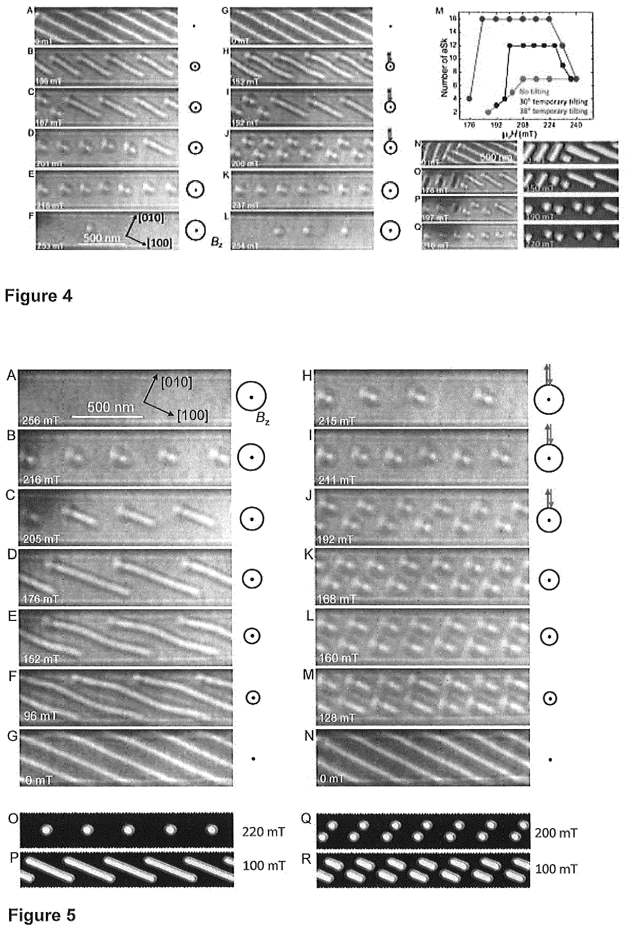

Figure 4 shows single and double chains of antiskyrmions. In the left column, the starting configuration (A) are helix segments that are elongated along the [100] direction, which is oriented at an angle $\varphi \approx -28°$ with respect to the racetrack direction. (B) Upon increasing the field, the helix segments shrink, until few antiskyrmions are formed in (C) at 187 mT. (D) For fields above 201 mT, almost all segments have turned into antiskyrmions, so that a chain of antiskyrmions is present in (E). (F) 253 mT: the antiskyrmions annihilate, until the ferromagnetic phase is restored. In the middle column, the procedure is changed. This time, the sample is reversibly tilted by 30° to provide a temporal in-plane field component before each image is taken. (G-I) At low fields, the magnetic texture mainly exhibits a helical phase, as in the left column. (J) However, at 200 mT a double row of antiskyrmions forms. (K) 237 mT: the number of antiskyrmions reduces and a single chain is restored. At 254 mT the sample becomes ferromagnetic in (L). In (M) the numbers of antiskyrmions (aSk) for the three scenarios are compared for different field strengths (red is without in-plane field, black and blue are after a ~30°, 38° temporary in-plane field. In (N-Q) the generation of an antiskyrmion chain starting from a mixed helical phase is shown. As in the left column, the magnetic field is not tilted in this case. On the right side, results of micromagnetic simulations are shown. Both helix types from (N) shrink and form antiskyrmions in (Q).

Figure 5 shows the evolution of single and double antiskyrmion chains upon decreasing the field. In the left column, (A) the starting configuration is a ferromagnet. (B) The field is simply decreased leading to the generation of antiskyrmions. (C-G) The antiskyrmions elongate until a helical phase is restored. In the right column, the starting configuration is again a ferromagnet. (H) This time the field is reduced under reversible tilting of the sample by 30° to provide a temporal in-plane magnetic field. This allows again for the stabilization of antiskyrmions. (I) They survive at 211 mT without elongation. (J) At 192 mT, a double chain of antiskyrmions forms. (K, L, M) When the field is decreased from here, these double chains of antiskyrmions elongate. (N) At zero field, the helical phase is restored. (O, P) The elongation process of an antiskyrmion chain is shown in micromagnetic simulations at different external fields. (Q, R) When more antiskyrmions are placed in the sample, a double chain of antiskyrmions is stabilized that elongates in a manner similar to the experiments.

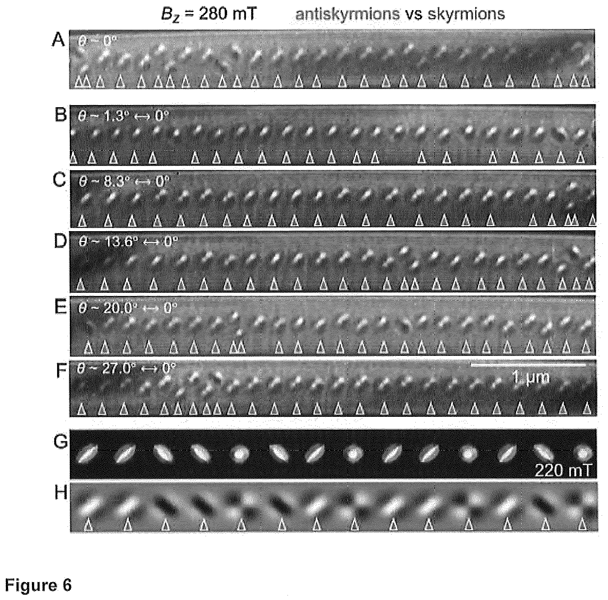

Figure 6 shows antiskyrmions versus elliptical skyrmions in a nano-stripe along the [$\bar{1}$10] direction. In (A) the initial configuration is shown consisting mainly of antiskyrmions and only showing 3 elliptical skyrmions which are elongated along the [010] direction and one elliptical skyrmion that is elongated along the [100] direction. In (B) the sample was reversibly tilted to provide a small in-plane field along the [100] direction. The result is mainly elliptical skyrmions. Most of them are elongated along the [100] direction. In (C-F) the same procedure is repeated but with larger tilting angles. The number of antiskyrmions increases. (G-H) Micromagnetic simulations and the corresponding simulated LTEM contrasts show the simultaneous existence of antiskyrmions and elliptical Bloch skyrmions.

## Detailed description of the Invention

Of special relevance for spintronic applications is the possibility of using non-collinear magnetic nano-objects as magnetic bits in racetrack data storage devices - namely arrays of nano-stripes in which topologically protected magnetic nano-objects like magnetic skyrmions or antiskyrmions are written, moved, read and deleted. These small "magnetic whirls" possess high stability due to their topological nature and they can be driven by comparably small currents.

Due to their topological charge, skyrmions experience a deflection along a transverse direction towards the edge of the racetrack, where they may become pinned or annihilate. Because of the rotational symmetry of skyrmions, this so-called skyrmion Hall effect is isotropic: it is present irrespective of the current orientation.

This is not the case in a material which has $D_{2d}$ symmetry (=magnetic point group $\bar{4}2m$) for which the inversion symmetry is broken so that the DMI vectors are anisotropic. For this reason, the stabilized nano-objects in this material are antiskyrmions that are only rotational invariant after a 180° rotation. This implies that antiskyrmions behave differently under applied currents along different crystal directions. The aforementioned skyrmion Hall Effect can even be absent for this special nano-object if the current is applied along a specific direction for which there is a particular magnetization profile of the antiskyrmion. Consequently, it is highly desirable to manufacture nano-tracks along different crystallographic directions, which exhibit differently oriented antiskyrmions.

A second advantage of systems with an anisotropic DMI is that the dipole-dipole interaction allows for a coexistence of elliptically elongated skyrmions along with the DMI mediated antiskyrmions. If both nano-objects - elliptically elongated skyrmions and antiskyrmions - are metastable in a nano-stripe, "0" and "1" bits can be encoded by a sequence of skyrmions and antiskyrmions instead of the presence or absence of a single object at predefined positions (like a magnetic domain wall). Using two distinct magnetic objects in a racetrack should make it less susceptible to diffusion or interactions between the topological objects that may be significant in conventional racetracks.

Accordingly, one aspect of the present invention comprises nano-stripes of compounds, which crystallize in the magnetic point group $\overline{4}2m$ with $D2d$ symmetry, which nano-stripes have an extension along a predefined crystallographic direction. Depending on the crystallographic direction in which these nano-stripes extend, single- and double-chains of antiskyrmions in multiple geometries as well as helical spin textures can be generated in these nano-stripes. The state of helical spin texture is the zero (ground) state of the nano-stripes when no prior magnetic field has been applied.

The present invention provides several reliable ways to generate chains of antiskyrmions in crystallographically and geometrically confined nano-stripes which exhibit an increased ease of the formation of antiskyrmions by comparison with extended lamellae due to the crystallographic and geometric confinement of the nano-stripe. This allows for the generation of antiskyrmions without the need for the application of in-plane magnetic fields that is needed in extended lamellae in order to stabilize the antiskyrmions.

According to the present invention a single chain of antiskyrmions can be formed in the middle of the track (nano-stripe) at room temperature which is contrary to recent observations in skyrmion systems which revealed an edge mediated nucleation of skyrmions at low temperatures (H. Du et al., Edge-mediated skyrmion chain and its collective dynamics in a confined geometry. Nat. Commun. 6, 8504 (2015); C. Jin et al., Control of morphology and formation of highly geometrically confined magnetic skyrmions. Nat. Commun. 8, 15569 (2017); C. Psaroudaki, S. Hoffman, J. Klinovaja, D. Loss, Quantum dynamics of skyrmions in chiral magnets. Physical Review X 7, 041045 (2017)) and crystals which were densely filled with skyrmions at room temperature. Such a structure is inconvenient for racetrack applications. In contrast thereto, in the present invention the coexistence of antiskyrmions and two types of elliptically elongated skyrmions under certain conditions is very promising for improving the reliability of magnetic racetrack devices.

Manufacture of the *nano-stripes*

The nano-stripes according to the present invention can be prepared from single-crystalline grains of polycrystalline bulk material of compounds, which crystallize in the tetragonal magnetic point group 42m with $D2d$ symmetry.

Initially polycrystalline ingots of these compounds are prepared, e.g. by arc-melting methods. A detailed preparation of the exemplary compound $Mn_{1.4}Pt_{0.9}Pd_{0.1}Sn$ is described by A. K. Nayak et al (Magnetic antiskyrmions above room temperature in tetragonal Heusler materials. Nature 548, 561 (2017)). Subsequently, nano-stripes can e.g. be lifted out of the polycrystalline material e.g. in a Nano lab dual beam system that has both a scanning electron microscope (SEM) and a focused ion beam (FIB) equipped with a gas injection system (GIS) and a micromanipulator (Oxford Omniprobe 200 +). Such a dual beam system is available e.g. at FEI Company (Hillsboro, Oregon, U.S.A.).

The nano-stripes are cut out so that they have

- a thickness of 5-500 nm, preferably 20-300 nm, more preferred 130-250 nm;
- a width of 10-1000 nm, preferably 200-750 nm, more preferred 350 to 500 nm and
- a length of 100-10000 nm, preferably 3000-8000 nm, more preferred 5000-6000 nm.

Figures 1F, G, I, J and Figs. 2-6 show such nano-stripes. The thicknesses are ~ 100 nm (for Figs. 1F, 1I, 2 and 3), ~200 nm (for Figs. 1G and 1J), and nearly 150 nm thickness for the nano-stripe in Figs. 4 and 5 as well as for the nano-stripe in Fig. 6.

Antiskyrmions are stabilized in the basal plane (=plane normal to [001]) of the tetragonal 42m structure. Therefore, in order to obtain/generate antiskyrmions, thin nano-stripes, which are oriented with the [001] direction perpendicular to the surface of the nano-stripe are needed.

Fig. 1A shows exemplarily how two stripes of $Mn_{1.4}Pt_{0.9}Pd_{0.1}Sn$ have been lifted out of the bulk sample by focused ion beam (FIB). SEM overviews of two differently oriented nano-stripes are shown in Figs. 1B and 1C. Figs. 1D and 1E are TEM overviews of the same nano-stripes. The nano-stripes can e.g. be lifted out using a $Ga^+$ focused ion beam. Electron back scattered diffraction (EBSD) can help to find regions of a [001] oriented grain from the bulk polycrystalline sample. The crystallographic directions are indicated in Figures (1D and 1E) by orange arrows. Cutting a nano-stripe along [010], produced the helical state as shown in figure (1F) and along [110] as shown in figure (1G). In this way nano-stripes can be lifted whose helical propagation direction with respect to the edge of the stripe can be varied.

The ground-state helices at zero magnetic field in $Mn_{1.4}Pt_{0.9}Pd_{0.1}Sn$ are always oriented along the family of {10} directions (like [100], [010], [110], [$\overline{1}$10] etc.), due to the anisotropic DMI. For this reason, the orientation of the helix axis with respect to the nano-stripe depends on the stripe orientation. In a [100] or [010] oriented nano-stripe the orientation of the helix axis with respect to the stripe direction, $\varphi$, can be 0° or 90°, whereas in a [110] or [110] oriented nano-stripe, $\varphi = \pm 45$°, as shown in Figs. 1F and 1G.

As mentioned above, antiskyrmions lack a continuous rotational symmetry due to the anisotropic DMI. The orientation of an antiskyrmion is strictly tied to the underlying crystallographic axes of the host. The profile of the magnetic texture of an antiskyrmion along the [100] or [010] directions corresponds to a Bloch wall, as indicated by the orange lines in Fig. 1H, whereas along the [110] or [110] orientations the magnetic texture profile corresponds to a Neel wall. In the LTEM images, only the Bloch parts give rise to any contrast. These are the bright and dark spots along the family of {10} directions with respect to the antiskyrmions' centers in Figs. 1I and 1J, which means they are rotated when comparing both nano-stripes. This is confirmed by micromagnetic simulations, similar to Figs. 1K and 1L.

**Formation of helices and antiskyrmions in [010] oriented nano-stripes.**

A nano-stripe was cut along the [010] direction. Starting from the ferromagnetic state at a perpendicularly applied magnetic field of 316 mT as shown in Fig. 2A, decreasing the perpendicularly applied magnetic field leads to the generation of a helical phase with a wave vector (Q-vector) in the [100] direction which is perpendicular to the nano-stripe direction of [010]. While in zero magnetic field, the spin texture of a helix in known extended lamellae (width of about >1000-6000 nm and a length of about 4500- 6000 nm) of a $D_{2d}$ material changes harmonically along the Q-vector (see: Adv. Mater. 2020, 32, 20002043), at increased fields the helix is distorted so that there are collinear ferromagnetic regions between individual segments of the helix in these known extended lamellae. In the nano-stripes of the present invention, however, the helix segments cannot be displaced from each other due to the crystallographic confinement (nano-stripes oriented along the family of {10} directions) and the physical size limitation, which is why a different creation and annihilation mechanism has to be present.

Starting from the ferromagnetic phase, at 227 mT, in Fig. 2B, a first helix segment forms that elongates upon further decreasing the field until it permeates the whole visible area of the nano-stripe (Fig. 2C). Across this segment, the magnetization changes by 360° (it is parallel to the field direction at the edges and oppositely in the center). At lower fields this process is repeated. First, with a second helix segment, shown in Figs. 2D and 2E, and, later, with a third helix segment, shown in Figs. 2F and 2G. The ratio of the area filled with helix segments over the ferromagnetic area is directly related to the external magnetic field, just as in known extended lamellae. However, due to the crystallographic and dimensional confinement, individual helix segments are generated or annihilated upon changing the field. This process is continuous, in the sense that an individual helix segment shrinks (elongates) upon increasing (decreasing) the magnetic field.

As observed, a helical phase with Q-vector along [100] is the ground state in a nano-stripe which extends in [010] direction, while in an extended lamella sample of $\geq 10$ $\mu m^2$ helices with a Q-vector along the [010] direction are energetically equivalent to those along the [100] direction. In the confined geometry of the nano-stripes of the present invention this latter state is less preferable energetically. A small number of long helix segments yields a lower energy than a larger number of short helix segments, since the edges of the segments cost energy, since they are highly non-collinear. However, when the perpendicular field is decreased whilst tilting the sample, i.e. an in-plane field component is provided to the nano-stripes of the present invention, this behavior changes, as is shown in Figs. 2H-2N. Similar to extended lamellae, providing an in-plane magnetic field favors the generation of antiskyrmions over helices, since the energy barrier between these phases is decreased. In an out of plane field of 245 mT, when the sample is tilted by 21° in Fig. 2J, a periodic chain of antiskyrmions has formed. Upon decreasing the field, at the same tilt angle, first, the number of antiskyrmions increases further, partially leading to a zig-zag pattern of the antiskyrmions due to the limited space in the nano-stripe (confined geometry). However, a dense zig-zag chain did not form. Instead, at further decreased fields, these distorted antiskyrmions start to elongate. Due to their interaction and due to the limited space along the nano-stripe (confined geometry), the elongation is, this time, along the perpendicular direction [100], see Fig. 2L. Slightly below zero field, all distorted antiskyrmions have turned into short helix segments and a periodic state has formed in Fig. 2N. This shows that also in nano-stripes the magnetic texture is strongly dependent on the field history, similar to the known extended lamellae. Furthermore, if the field is decreased in an uncontrolled manner, e.g. by turning it off instantly, the resulting zero-field configuration consists of several helix domains either oriented along the [100] or [010] directions.

In Fig. 3, the behavior of the magnetic texture upon increasing the magnetic field from the three aforementioned starting configurations (Q-vectors along [100], Q-vectors along [010] and mixed state) is shown. In Fig. 3A the helix Q-vector is along the [100] direction, i.e. the helix segments are elongated along the nano-stripe. The increasing field behavior is roughly the reversal of the decreasing field behavior (Figs. 3B-3E).

The helix segments shrink and disappear one after another. Likewise, when the starting configuration consists of a helix with a Q-vector along [010] (Fig. 3F), the increasing field behavior is similar to the decreasing field behavior. The helix segments that are perpendicular to the nano-stripe shrink (Fig. 3G) until a periodic chain of antiskyrmions is formed (Fig. 3H). Upon further increasing the field, the nano-objects disappear, one after another (Fig. 3I), until the ferromagnetic state is restored.

What is, however, notable is that this time the field is increased without providing an in-plane field component and antiskyrmions form anyway. This implies that the truncated helix segments at zero-field are still topologically non-trivial; they are topologically protected. The results of micromagnetic simulations (Fig. 3P-3R) reveal that each helix segment consists of a topologically trivial center part that can have different lengths. However, the helix edges always exhibit the profile of half an antiskyrmion, each due to the anisotropic DMI that leads to the same edge twist even for differently shaped objects: For example, the upper edges of the helix segments in Fig. 3R and the antiskyrmions in Fig. 3Q have the same in-plane configuration (red-orange-yellow-green color code), independent of the shape of the object. Therefore, both edge parts of a helix segment possess a topological charge of ½ each. An individual helix segment can - therefore - be considered an "elongated antiskyrmion".

Antiskyrmion formation without providing in-plane fields was not observed in extended lamellae so far, pointing towards an increased stability of antiskyrmions in confined geometries like the ones in the nano-stripes of the present invention. The shrinking helix mechanism for antiskyrmion generation is directly related to the confinement. Following from the one-to-one correspondence of helix segments and antiskyrmions in the case of vertically oriented helix segments (Fig. 3F-3J), it is conceivable that horizontally oriented helix segments also condense to single antiskyrmions. However, since in a perfect sample, only three helix segments permeate the whole nano-stripe, the resulting antiskyrmion density is vanishingly small in this procedure and no antiskyrmions are visible in Figs. 3A-3E.

Furthermore, it is worth mentioning that, even though the formation of the antiskyrmions is strongly affected by the confinement, the antiskyrmions form always in the middle of the nano-stripe, unlike edge-mediated skyrmions presented in the known B20 material FeGe. The experiments were repeated with wider nano-stripes with a width of 490nm (cf. Fig. 1 J) and it was found again that the antiskyrmions always form in the middle of the nano-stripe. The maximum width for which this phenomenon is observed is about 1000 nm. Beyond this width there will be more than a single chain of nano-objects.

In B20 materials, for example FeGe, the single skyrmions are only found when the width of the stripe is about the size of the individual nano-objects (skyrmion). When the width of the stripe is larger than the individual nano-objects, more rows of nano-objects are formed (Ref_ H. Du et al., Edge-mediated skyrmion chain and its collective dynamics in a confined geometry. Nat. Commun. 6, 8504 (2015); C. Jin et al., Control of morphology and formation of highly geometrically confined magnetic skyrmions. Nat. Commun. 8, 15569 (2017). This is in clear contrast to the present nano-stripes made of $D_{2d}$ material. In $D_{2d}$ nano-stripes of the present invention, the single chain of antiskyrmions forms even if the width is larger than the individual nano-object (antiskyrmion). This phenomenon is observed up to a width of about 1000 nm.

Repeating the increasing field experiment starting from the mixed helical configuration ([100] + [010]) (Fig. 3K) is particularly interesting, as it reveals more about the interaction of helix segments and antiskyrmions. The starting configuration consists of one horizontal helix segment at the bottom in Fig. 3K. The rest of the nano-stripe is filled with vertical segments on the right side and two more horizontal segments on the left side. Upon increasing the magnetic field to 158 mT in Fig. 3L, the vertical helix segments begin to shrink and one of the upper horizontal segments disappears. When the field is further increased in Fig. 3M, the long horizontal helix segment shrinks and is only visible on the right side of the stripe region shown. Consequently, the vertically oriented segments in the middle can elongate again and the one remaining horizontal segment on the left moves to the middle of the nano-stripe. Near the transition to the ferromagnetic phase in Fig. 3O, all helix segments have shrunk and formed antiskyrmions. Reminiscent of the initial helix orientation, a small deformation is still present for the antiskyrmions in this LTEM image. The antiskyrmion on the left has a notably different contrast, indicating elongation along the nano-stripe, while the others are slightly elongated along the perpendicular direction.

These LTEM results are supported by the results of micromagnetic simulations. Fig. 3P shows the stability of an extended helix and another helix that starts in the middle of the frame. The longer helix segment is located in the middle of the nano-stripe in the right part of the nano-stripe but is shifted to the top in the left half where the second helix segment is present, similar to the experimental observations. Furthermore, upon slightly increasing the field, the shorter helix segment shrinks while it increases its size upon decreasing the field. In Fig. 3Q a chain of antiskyrmions is present, qualitatively reproducing the experimental findings from Fig. 3H. Fig. 3R shows the metastability of a mixed helical phase. These simulations were each initialized with a different analytically constructed magnetization density that was relaxed for at least 1 ns.

**Antiskyrmion chains in differently oriented nano-stripes.**

Due to the antiskyrmions' lack of rotational symmetry, it is interesting to investigate antiskyrmions in differently oriented nano-stripes. A nano-stripe was prepared where the orientation was rotated by $\varphi \approx -28°$ (i.e. in clockwise direction) with respect to the [100] crystallographic axis. In Figs. 4 and 5, the decreasing and increasing field behaviors of the magnetic texture are shown.

Again, the ground state is the helical phase. This time, the helix Q-vectors are rotated by $\varphi$ compared to the

helices in the nano-stripe discussed above. This can be contrasted with known B20 materials, where a strong anisotropy to the helix orientation is induced so that they always form perpendicular or parallel to the edge. Even though the two types of helices are not aligned parallel or perpendicular to the nano-stripe direction in the present $D_{2d}$ system for the nano-stripe shown in Fig. 4 and 5, one of the two helix types exhibit longer segments than the other when these permeate the whole width of the nano-stripe. Similar to the case presented above, the helical phase with the longer segments has the lower energy, since then the density of the ends of the helixes is decreased. Due to this special feature of textures in such a confined geometry, the starting configuration (shown in Fig. 4A) consists of helix segments that are oriented along a direction rotated by $\varphi$ with respect to the nano-stripe direction, [100]. Upon increasing the field (Fig. 4B-4E), the lengths of the segments shrink until antiskyrmions are formed. In agreement with the theoretical predictions, the two bright and dark spots in the LTEM contrast are rotated by $\varphi$- 90° compared to the antiskyrmions in Fig. 3 pointing towards the anisotropic properties of antiskyrmions. At higher fields, the antiskyrmions annihilate. When the field is increased to 253 mT in Fig. 4F, only a single nano-object is left. At slightly higher fields this object disappears.

The formation of an antiskyrmion chain without providing in-plane magnetic fields (which would be unfavorable for spintronic devices) is very interesting for racetrack applications. The mechanism relies on the fact that the helix segments are truncated at the edges and it is, therefore, highly relevant in confined geometries according to the present invention compared to extended lamellae. This mechanism is compared for antiskyrmion nucleation in nano-stripes to the more conventional mechanism (that uses tilting) that has been extensively explored in extended lamellae.

The effect of temporal in-plane fields was investigated by tilting the sample by ~30° after each increase in field and then back to zero tilt once the target field was reached. It was found that now a double row of antiskyrmions can sometimes be formed rather than a single row. As explained, the topology of the truncated helices and the single row of antiskyrmions is the same. Therefore, they can easily transform from one to the other. On the other hand, a topological transformation is needed when the truncated helices transform into a double row of antiskyrmions; in this case an energy barrier has to be overcome. Tilting provides an in-plane field component that helps overcoming this energy barrier. Thus, there are two distinct mechanisms for the transformation of the truncated helices into antiskyrmions. Figs. 4A-4L compare a sequence of LTEM images for the same nano-stripe with and without this tilting procedure as the field is increased from zero. A similar behavior is seen at low fields whether tilting is used or not: the helical phase is found. In the field range starting from ~190 mT, a double row of antiskyrmions is observed in case of tilting, instead of a single row without tilting. When the field is increased without tilting (Figs. 4A-4F), the helix segments shrink to antiskyrmions and no "new" antiskyrmions are formed. With tilting (Figs. 4G-4L), the topologically induced energy barrier can be overcome and a greater density of antiskyrmions is found. Fig. 4M shows quantitatively how the number of antiskyrmions increases due to tilting. This is similar to extended lamellae, where a temporal in-plane magnetic field leads to the formation of a hexagonal lattice of antiskyrmions. In the nano-stripes of the present invention, this lattice appears in its minimal shape: a zig-zag chain of antiskyrmions can be seen as a precursor of the antiskyrmion lattice. When the field is increased further, the antiskyrmions start to annihilate one after another both with and without tilting. For the case of tilting, the double row evolves into a single antiskyrmion chain at ~237 mT (Fig. 4K) and at even higher fields the ferromagnetic phase is restored.

The dependence of the antiskyrmion formation on the tilting angle has also been investigated. For small tilt angles (<~ 25°), no double rows of antiskyrmions are found. The in-plane field component (that increases with tilt angle) is not large enough to overcome the energy barrier between the truncated helices and the double chain of antiskyrmions. Consequently, only a single row of antiskyrmions forms. For large tilting angles, qualitatively the same behavior as for 30° is seen (described above). However, the double row of antiskyrmions forms at lower total magnetic fields. This stems from the fact that the in-plane field component, that is necessary for a formation of a double row of antiskyrmions, is already reached at a smaller total field. Furthermore, the antiskyrmions in the double row are more densely packed. On the other hand, the critical field that characterizes the transformation from a double to a single row of antiskyrmions at high fields is insensitive to tilting angle because this mechanism is not related to the tilting. It is rather a regular transition to the ferromagnetic phase. These results are summarized in Fig. 4M and underline the interpretation of two separate mechanisms for the antiskyrmion formation: one caused by the topological equivalence of single rows of antiskyrmions and truncated helix segments (only important in nano-stripes) and the other caused by in-plane fields (important in nano-stripes and in extended lamellae).

Concerning the helix orientation with respect to the nano-stripe orientation, for the aforementioned geometrical reasons, the closer $\varphi$ is to 45°, the closer the two helical orientations are in energy balance. In such a case, the formation of helical domains becomes inevitable. Hence, nano-stripes whose orientation is rotated are preferred over those with $\varphi \approx 0°$ or 90° for racetrack manufacture. Therefore, the behavior of the magnetic texture was also investigated as the field is increased when the starting configuration is a multi-domain helical phase. Fig. 4N-4Q shows a nano-stripe with $\varphi \approx$ -28° like above, but in which two helices can be seen with Q-vectors approximately along the [100] and [010] axes. In Fig. 4N it becomes apparent that the helix orientation is slightly affected by the edge interaction. The two types of helix segments do not form at an angle of exactly 90° (but $\pm 4°$), as distinct from helices in extended lamellae. Furthermore, the corresponding helix segments have different lengths. When the field is increased, both type of helices shrink until a single chain of antiskyrmions is formed in Fig. 4Q. A qualitatively similar behavior is found in the micromagnetic simulations when starting from a mixed helical phase.

When the field is decreased starting from the ferromagnetic phase (Fig. 5A) one also finds a distinct behavior. Most importantly, when a temporal in-plane field is not provided, antiskyrmions form at fields near 216 mT in Fig. 5B. This was not the case for the initially investigated nano-stripe that was oriented along the high-symmetric [010] direction. Instead of forming one single helix segment that elongates along the nano-stripe, in the present nano-stripe many antiskyrmions form, since a single helix segment cannot much elongate due to the considerable angle $\varphi$ between the nano-stripe orientation and the high-symmetry directions. Upon further decreasing the field, the antiskyrmions elongate along [100], which is the longer of the two possible helix directions (Figs. 5C-5G). When instead a temporal in-plane magnetic field is provided, one finds a different behavior. First, only a few antiskyrmions are seen in Fig. 5H at a field of 215 mT. At a decreased field of 211 mT more antiskyrmions are present and constitute a dense chain in Fig. 5I. At a field of 192 mT enough antiskyrmions are present that a zig-zag double chain forms in Fig. 5J. When the field is decreased again, one can see how the antiskyrmions in this double chain elongate (Figs. 5K-5M). Again, they do this along the [100] direction but, due to the limited space, they cannot elongate to permeate the whole width of the nano-stripe. At zero field, the helical phase is restored (Fig. 5N).

In Figs. 5O and 5Q the metastability of single and double antiskyrmion chains are shown from the results of micromagnetic simulations. Upon decreasing the magnetic field, the antiskyrmions elongate along the [100] direction in both cases (Figs. 5P, 5R).

## Coexistence of skyrmions and antiskyrmions.

Recently, the coexistence of antiskyrmions and elliptically deformed skyrmions was shown in $Mn_{1.4}Pt_{0.9}Pd_{0.1}Sn$ extended lamellae (see: J. Jena et al., Elliptical Bloch skyrmion chiral twins in an antiskyrmion system. Nat. Commun. 11, 1115 (2020); and L. Peng et al., Controlled transformation of skyrmions and antiskyrmions in a non-centrosymmetric magnet. Nat. Nanotechnol., 1-6 (2020)). The elliptical skyrmions are of the Bloch type that are stabilized by dipole-dipole interactions that allow for both Bloch chiralities. Depending on the chirality, the anisotropic DMI then leads to their elongation along the [100] or [010] direction, respectively.

In the nano-stripes of the present invention one also finds elliptical skyrmions. Fig. 6 shows LTEM images of the magnetic texture in a $\varphi \approx 45°$ nano-stripe for various temporal tilting angles. The Bloch skyrmions appear as elliptical objects with a dark center and a bright ring outside when elongated along the [010] direction or as elliptical objects with a bright center and a dark ring outside when elongated along the [100] direction. The starting configuration of the nano-stripes according to the present invention is a chain of antiskyrmions that has been generated using tilting as discussed above. Here one already finds a few elliptical skyrmions.

The reason is that small temporal in-plane fields stabilize the formation of elliptical skyrmions. In Fig. 6B the temporal tilting angle used was only 1.3°. As a result, all the antiskyrmions have turned into Bloch elliptical skyrmions. Arguably, for some of them it is not possible to unambiguously determine their exact magnetic state, but a comparison with the initial configuration (Fig. 6A) shows clearly that the magnetic contrast has changed. When one now uses a larger tilting temporal angle, again more antiskyrmions are found (i.e. 11 antiskyrmions vs. 12 skyrmions in Fig. 6C). The experiment was operated with multiple temporal tilting angles until at a tilting angle of 27° the texture mainly consists of antiskyrmions (Fig. 6E), as was presented in the cases above. Repeating these experiments at tilting angles of 1.3° and 27° several times gave identical results: a single chain of elliptical Bloch skyrmions vs. a single chain of mostly antiskyrmions. Thus, between ~1.0° and 27.5° there is a co-existence with a varying balance of Bloch skyrmions and antiskyrmions. Below ~1.0° one finds only Bloch skyrmions, and above 27.5° one finds only antiskyrmions. In Fig. 6G it is shown that elliptical skyrmions and antiskyrmions can be stabilized in micromagnetic simulations of a nano-stripe when the anisotropic DMI and the dipole-dipole interaction are considered. For the simulation parameters that are used, both objects are stable for fields up to 220 mT. Fig. 6H shows the corresponding simulated LTEM contrast. It becomes apparent that antiskyrmions and one type of elliptical skyrmion look rather similar, explaining why it is sometimes difficult to distinguish antiskyrmions and elliptical skyrmions in the LTEM experiment. In a device, they could be distinguished electrically by their different Hall signatures.

In summary, the present invention provides for the room temperature formation of various antiskyrmion chains (for example from truncated helices). Single chains of antiskyrmions are formed along the middle of nano-stripes formed from a $D_{2d}$ material even when the nano-stripe is much wider than the individual antiskyrmions and without providing any in-plane magnetic field. This nucleation mechanism is related to the topological equivalence of antiskyrmions and truncated helix segments. It is relevant in confined geometries and is distinct from the temporal in-plane field mechanism described for extended thin lamellae. Furthermore, it has been shown that these chains of antiskyrmions can coexist at room temperature (about 25°C) with elliptical Bloch skyrmions. This is a very attractive feature that allows the possibility of robust memory or computing devices that can encode data in these systems in two distinct topologically protected objects (antiskyrmions and elliptical Bloch skyrmions).

Methods

Polycrystalline ingots of $Mn_{1.4}Pt_{0.9}Pd_{0.1}Sn$ were prepared by arc-melting methods. The detailed preparation as well as structural and magnetic characterization are described in A. K. Nayak et al., Magnetic antiskyrmions above room temperature in tetragonal Heusler materials. Nature 548, 561 (2017). Nano-stripes were prepared in a Nano lab dual beam system that has both a scanning electron microscope (SEM) and a focused ion beam (FIB) equipped with a gas injection system (GIS) and a micromanipulator (Oxford Omniprobe 200 +) at FEI Company. The final polishing was done at 2 kV to remove any damaged surface material. Four different nano-stripes are used for the above described determinations, all prepared with the same method. The thicknesses are ~ 100 nm (for Figs. 1F, 1I, 2 and 3), ~200 nm for Figs. 1G and 1J), and nearly 150 nm thickness for the stripe in Figs. 4 and 5 as well as for the stripe in Fig. 6.

The observation of magnetic contrast was carried out in a TEM (FEI, TITAN 80-300KV) equipped with an electrostatic mini-lens for Lorentz imaging. The objective lens of the TEM was used to realize magnetic fields along the microscope axis corresponding to zero-tilt of the sample. A double tilt sample holder was used. Selected area electron diffraction (SAED) was used to identify grains within the polycrystalline sample that were oriented with the [001] axis at zero tilt. All the LTEM contrasts have imaged on the defocused value of nearly from 1.1 to 1.2 mm.

Micromagnetic simulations were carried out using Mumax3 (A. Vansteenkiste et al., The design and verification of MuMax3 AIP Adv. (2014). and A. Vansteenkiste, B. Van de Wiele, MuMax: A new high-performance micromagnetic simulation tool. J. Magn. Magn. Mater. 323, 2585-2591 (2011). This program propagates the Landau-Lifshitz-Gilbert equation for every discretized magnetization cell according to:

$$\dot{\mathbf{m}} = -\gamma_e\,\mathbf{m} \times \mathbf{B}_{\mathrm{eff}} + \alpha\,\mathbf{m} \times \dot{\mathbf{m}}.$$

Here, **m** is the normalized moment, $\gamma_e$ is the gyromagnetic ratio of an electron, $\alpha$ = 0.03 is the Gilbert damping parameter,

$$\mathbf{B}_{\mathrm{eff}} = -\frac{\delta F}{M_S \delta \mathbf{m}}$$

and is the effective magnetic field. This quantity is derived from the free energy density $F$ for which the Heisenberg exchange, a uniaxial magnetic anisotropy, the external magnetic field, and dipole-dipole interactions have been included. Furthermore, an anisotropic DMI was implemented that corresponds to the $D_{2d}$ symmetry of the crystals under study. The following parameters were applied: the measured saturation magnetization $M_s$ = 445 kA/m, the exchange interaction $A_{ex}$ = 0.5 × 10$^{-10}$ J/m, the DMI constant $D$ = 0.003 J/m$^2$, and the anisotropy constant $K_u$ = 135 kJ/m$^3$. The parameters have been adjusted to fit better the experimental results. The magnetic field strength is indicated in the respective image. In all simulations periodic boundary conditions are applied along the nano-stripe. The simulated length is 4200 nm, the thickness is 150 nm and the width is 400 nm or 600 nm. In most cases, only half of the simulated length is shown in the figure. The magnetization density was discretized in 10 nm × 10 nm × 10 nm cells, except for Fig. 6 where a finer grid of 2.5 nm × 2.5 nm × 10 nm was necessary. Also, the stability of elliptical skyrmions and antiskyrmions were checked in a finite geometry and all shown textures were stabilized using the direct energy minimization solver ("minimize") based on the conjugate gradient method (CGM).

Lorentz TEM simulations

The LTEM image was simulated in Fig. 6H. The transmitted electron density, i.e., the LTEM contrast is given as

$$\int exp\left\{-\left[\left(x - d \cdot m_y(x',y') - x'\right)^2 + \left(y + d \cdot m_x(x',y') - y'\right)^2\right]/a^2\right\} dx'dy'.$$

The average magnetization of all layers leads to a deflection (maximum d = 2 nm) of the incoming electron beams according to the Lorentz force. The individual beams have been modeled by a Gaussian function with a smearing factor a = 60 nm.

**Claims**

1. A nano-stripe of a compound, which crystallizes in the magnetic point group $\overline{4}2m$ with *D2d* symmetry wherein the nano-stripe has

- a thickness of 5-500 nm,
- a width of 10-1000 nm, and
- a length of 100-10000 nm.

2. The nano-stripe according to claim 1, wherein the compound is a tetragonal ferro-, ferri-or antiferro-magnetic Heusler compound, a chalcopyrite, a stannite or a kesterite.

3. The nano-stripe according to claim 1 or 2, wherein the compound is selected from the group consisting of $Mn_{1.4}PtSn$, $Mn_{1.4}Pt_{0.9}Pd_{0.1}Sn$, $Mn_2RhSn$, $Mn_2IrSn$, $Mn_2Rh_{0.95}Ir_{0.05}Sn$, $Mn_2NiGa$, $Mn_2PtIn$, $Mn_2NiSb$, $Ni_2MnGa$, $Co_2MnGa$, $Cu_2MnSb$, NiCrSi, NiCrGe and NiCrGa.

4. The nano-stripe according to claim 1, 2 or 3, exhibiting the simultaneous presence of antiskyrmions and Bloch skyrmions, specifically elliptical Bloch Skyrmions.

5. The nano-stripe according to claim 4, exhibiting single and/or double chains of antiskyrmions.

6. The nano-stripe according to one of claims 1 to 5, exhibiting antiskyrmions in the absence of an in-plane magnetic field component.

7. The nano-stripe according to one of claims 1 to 6, wherein the nano-stripe is cut such that the crystallographic [001] direction is perpendicular to the surface of the nano-stripe.

8. The nano-stripe according to one of claims 1 to 7, wherein the nano-stripe is cut along the [010] or [100] or [110] or [110] crystallographic axis.

9. The nano-stripe according to one of claims 1 to 8, wherein the nano-stripe is cut such that its [010] or [100] orientation is rotated against the cutting edge by an angle $\varphi$ of between ~1.0° and 27.5° exhibiting a co-existence of Bloch skyrmions and antiskyrmions.

10. Manufacture of a nano-stripes according to claim 1 comprising preparing single-crystalline grains from polycrystalline bulk material of compounds, which crystallize in the tetragonal magnetic point group $\bar{4}2m$ with *D2d* symmetry and subsequent lifting out of the single-crystalline grains with the aid of a dual beam system such that the nano-stripes have

- a thickness of 5-500 nm;
- a width of 10-1000 nm and
- a length of 100-10000 nm.

11. Use of a nano-stripe according to one of claims 1-10 in spintronic applications, such as memory storage systems, and particularly memory storage systems that use current to move magnetic nano-objects, specifically in a magnetic racetrack.

12. A memory array device comprising a nano-stripe according to claim 1.

Skyrmion Figure

Figure 1

Figure 2

Figure 3

Figure 4

Figure 5

$B_z = 280$ mT    antiskyrmions vs skyrmions

Figure 6

Europäisches Patentamt

European Patent Office

Office européen des brevets

## EUROPEAN SEARCH REPORT

Application Number

EP 20 21 1514

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| X,D | JENA JAGANNATH ET AL: "Elliptical Bloch skyrmion chiral twins in an antiskyrmion system", NATURE COMMUNICATIONS, vol. 11, no. 1, 28 February 2020 (2020-02-28), pages 1-9, XP55802346, DOI: 10.1038/s41467-020-14925-6 Retrieved from the Internet: URL:https://www.nature.com/articles/s41467-020-14925-6.pdf> * page 1, paragraph 1 - page 8, left-hand column, paragraph 1; figures 1-7 * | 1-12 | INV. G11C11/16 H01L43/10 |
| X | BOERGE GOEBEL ET AL: "Beyond skyrmions: Review and perspectives of alternative magnetic quasiparticles", ARXIV.ORG, CORNELL UNIVERSITY LIBRARY, 201 OLIN LIBRARY CORNELL UNIVERSITY ITHACA, NY 14853, 4 May 2020 (2020-05-04), pages 1-19, XP081658644, * page 8, left-hand column, paragraph 2 - page 9, left-hand column, paragraph 2; figure 8(a) * | 1-5,11, 12 | |
| | -/-- | | TECHNICAL FIELDS SEARCHED (IPC) G11C H02N H01L |

The present search report has been drawn up for all claims

| Place of search | Date of completion of the search | Examiner |
|---|---|---|
| The Hague | 11 May 2021 | Colling, Pierre |

EPO FORM 1503 03.82 (P04C01)

Europäisches Patentamt

European Patent Office

Office européen des brevets

**EUROPEAN SEARCH REPORT**

Application Number

EP 20 21 1514

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | PENG LICONG ET AL: "Controlled transformation of skyrmions and antiskyrmions in a non-centrosymmetric magnet", NATURE NANOTECHNOLOGY, NATURE PUB. GROUP, INC, LONDON, vol. 15, no. 3, 20 January 2020 (2020-01-20), pages 181-186, XP037061309, ISSN: 1748-3387, DOI: 10.1038/S41565-019-0616-6 [retrieved on 2020-01-20] * page 1, left-hand column, paragraph 1 - page 4, left-hand column, paragraph 1; figures 1-3 * | 1,3,7, 11,12 | |
| X | DAIGO SHIMIZU ET AL: "Interaction between skyrmions and antiskyrmions in a coexisting phase of a Heusler material", ARXIV.ORG, CORNELL UNIVERSITY LIBRARY, 201 OLIN LIBRARY CORNELL UNIVERSITY ITHACA, NY 14853, 17 August 2020 (2020-08-17), XP081742716, * page 1, paragraph 1 - page 3, paragraph 2; figure 1 * | 1-3,11, 12 | |

TECHNICAL FIELDS SEARCHED (IPC)

-/--

The present search report has been drawn up for all claims

| Place of search | Date of completion of the search | Examiner |
|---|---|---|
| The Hague | 11 May 2021 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | NAYAK AJAYA K. ET AL: "Magnetic antiskyrmions above room temperature in tetragonal Heusler materials", NATURE, vol. 548, no. 7669, 31 August 2017 (2017-08-31), pages 561-566, XP055802646, London ISSN: 0028-0836, DOI: 10.1038/nature23466 Retrieved from the Internet: URL:https://www.nature.com/articles/nature23466.pdf> * page 561, right-hand column, last paragraph - page 566, right-hand column, paragraph 1; figures 1-4 * | 1-3,11 | |
| A | ZHIPENG HOU ET AL: "Creation of Single Chain of Nanoscale Skyrmion Bubbles with Record-high Temperature Stability in a Geometrically Confined Nanostripe", ARXIV.ORG, CORNELL UNIVERSITY LIBRARY, 201 OLIN LIBRARY CORNELL UNIVERSITY ITHACA, NY 14853, 25 November 2019 (2019-11-25), pages 1-19, XP081538826, * page 5, paragraph 2 - page 9, last paragraph; figure 3(f) * | 1-12 | |

TECHNICAL FIELDS
SEARCHED (IPC)

The present search report has been drawn up for all claims

| Place of search | Date of completion of the search | Examiner |
|---|---|---|
| The Hague | 11 May 2021 | Colling, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6834005 B
- US 2014204648 A
- US 20140009994 A
- US 20140009993 A
- EP 3171364 A1

### Non-patent literature cited in the description

- **H. DU et al.** Edge-mediated skyrmion chain and its collective dynamics in a confined geometry. *Nat. Commun.,* 2015, vol. 6, 8504
- **C. JIN et al.** Control of morphology and formation of highly geometrically confined magnetic skyrmions. *Nat. Commun.,* 2017, vol. 8, 15569
- **C. PSAROUDAKI ; S. HOFFMAN ; J. KLINOVAJA ; D. LOSS.** Quantum dynamics of skyrmions in chiral magnets. *Physical Review,* 2017, vol. X 7, 041045
- **A. K. NAYAK et al.** Magnetic antiskyrmions above room temperature in tetragonal Heusler materials. *Nature,* 2017, vol. 548, 561
- *Adv. Mater.,* 2020, vol. 32, 20002043
- **J. JENA et al.** Elliptical Bloch skyrmion chiral twins in an antiskyrmion system. *Nat. Commun.,* 2020, vol. 11, 1115
- **L. PENG et al.** Controlled transformation of skyrmions and antiskyrmions in a non-centrosymmetric magnet. *Nat. Nanotechnol.,* 2020, 1-6
- **A. VANSTEENKISTE et al.** *The design and verification of MuMax3 AIP Adv.,* 2014
- **A. VANSTEENKISTE ; B. VAN DE WIELE.** MuMax: A new high-performance micromagnetic simulation tool. *J. Magn. Magn. Mater.,* 2011, vol. 323, 2585-2591